# EUROPEAN PATENT APPLICATION

(11) **EP 4 746 620 A1**
(43) Date of publication of application: **20.05.2026**
(21) Application number: 25215746.6
(22) Date of filing: 13.11.2025
(51) Int. Cl.: H10B 12/00

(54) **SEMICONDUCTOR DEVICES HAVING CONTACT STRUCTURES**

(30) Priority: 18.11.2024 KR 20240164364
(71) Applicant: Samsung Electronics Co., Ltd., Suwon-si, Gyeonggi-do 16677 (KR)
(72) Inventor: KANG, Yoongoo, 16677 Suwon-si (KR); LEE, Hyeryeong, 16677 Suwon-si (KR); WON, Seokjae, 16677 Suwon-si (KR); AHN, Seojin, 16677 Suwon-si (KR); PARK, Jaehong, 16677 Suwon-si (KR); KIM, Cheolho, 16677 Suwon-si (KR); KIM, Doohee, 16677 Suwon-si (KR); KIM, Namgun, 16677 Suwon-si (KR)
(74) Representative: Marks & Clerk LLP

(57) **Abstract**

A semiconductor device includes: a substrate; an active region in the substrate; a device isolation layer defining the active region; a gate structure in the substrate and extending across the active region in a first horizontal direction; bit line structures on the substrate, extending in a second horizontal direction intersecting the first horizontal direction, and crossing the gate structure; and a contact structure between the bit line structures, wherein the contact structure includes: a first contact plug in contact with the active region; a second contact plug on the first contact plug; and a third contact plug on the second contact plug, and wherein a first vertical central axis of the active region, a second vertical central axis of the first contact plug, and a third vertical central axis of the third contact plug are offset from each other in a cross-sectional view.

## Description

### BACKGROUND

The present disclosure relates to semiconductor devices including contact structures.

As demand for high performance, high speed, and/or multi-functionality of semiconductor devices increases, the integration of semiconductor devices is increasing. In manufacturing semiconductor devices with fine patterns corresponding to the trend toward high integration of semiconductor devices, it is required to implement patterns having fine widths or fine spacing.

### SUMMARY

One or more example embodiments provide a semiconductor device including a contact structure including first, second, and third contact plugs.

According to an aspect of the disclosure, a semiconductor device includes: a substrate; an active region in the substrate; a device isolation layer defining the active region; a gate structure in the substrate and extending across the active region in a first horizontal direction; bit line structures on the substrate, extending in a second horizontal direction intersecting the first horizontal direction, and crossing the gate structure; and a contact structure between the bit line structures, wherein the contact structure includes: a first contact plug in contact with the active region; a second contact plug on the first contact plug; and a third contact plug on the second contact plug, and wherein a first vertical central axis of the active region, a second vertical central axis of the first contact plug, and a third vertical central axis of the third contact plug are offset from each other in a cross-sectional view.

According to an aspect of the disclosure, a semiconductor device includes: a substrate; an active region in the substrate; a device isolation layer defining the active region; a gate structure in the substrate and extending across the active region in a first horizontal direction; bit line structures on the substrate, extending in a second horizontal direction intersecting the first horizontal direction, and crossing the gate structure; and a contact structure between the bit line structures, wherein the contact structure includes: a first contact plug in contact with the active region; a second contact plug on the first contact plug; and a third contact plug on the second contact plug, and wherein the device isolation layer includes a lower portion that is lower than an upper surface of the active region, and an upper portion that is higher than the upper surface of the active region.

According to an aspect of the disclosure, a semiconductor device includes: a substrate; an active region in the substrate and including a first impurity region and a second impurity region; a device isolation layer defining the active region; a gate structure in the substrate and extending across the active region in a first horizontal direction; bit line structures on the substrate, extending in a second horizontal direction intersecting the first horizontal direction, and crossing the gate structure; a contact structure between the bit line structures; a landing pad on the contact structure; and a capacitor structure on the landing pad, wherein the bit line structures include a bit line contact in contact with the first impurity region, wherein the contact structure includes: a first contact plug in contact with the active region; a second contact plug on the first contact plug; and a third contact plug on the second contact plug, wherein the first contact plug, the second contact plug and the third contact plug include single crystal silicon, and wherein a first vertical central axis of the second impurity region, a second vertical central axis of the first contact plug, and a third vertical central axis of the third contact plug are offset from each other in a cross-sectional view.

At least some of the above and other features of the invention are set out in the claims.

### BRIEF DESCRIPTION OF THE DRAWINGS

The above and other aspects, features, and advantages of the present disclosure will be more clearly understood from the following detailed description, taken in conjunction with the accompanying drawings, in which:
FIG. 1 is a plan view of a semiconductor device according to one or more embodiments;
FIG. 2 is a vertical cross-sectional view taken along lines I-I' and II-II' of the semiconductor device illustrated in FIG. 1;
FIG. 3 is a vertical cross-sectional view taken along line III-III' of the semiconductor device illustrated in FIG. 1;
FIG. 4 is an enlarged view of a portion of FIG. 2;
FIGS. 5, 6 and 7 are vertical cross-sectional views of semiconductor devices according to one or more embodiments; and
FIGS. 8A, 8B, 8C, 9A, 9B, 9C, 10A, 10B, 10C, 11A, 11B, 12A, 12B, 13A, 13B, 13C, 14A, 14B, 14C, 15A, 15B, 15C, 16A, 16B, 16C, 17A, 17B, 17C, 18A, 18B, and 18C are plan views and vertical cross-sectional views illustrated according to a process sequence illustrating a method of manufacturing a semiconductor device according to one or more embodiments.

### DETAILED DESCRIPTION

Hereinafter, example embodiments will be described with reference to the attached drawings.

It will be understood that when an element is referred to as being "connected" with or to another element, it can be directly or indirectly connected to the other element.

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

As used herein, the expression "at least one of a, b and c" indicates "only a," "only b," "only c," "both a and b," "both a and c," "both b and c," and "all of a, b, and c."

It will be understood that, although the terms "first", "second", "third", etc., may be used herein to describe various elements, is the disclosure should not be limited by these terms. These terms are only used to distinguish one element from another element.

As used herein, the singular forms "a," "an" and "the" are intended to include the plural forms as well, unless the context clearly indicates otherwise.

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

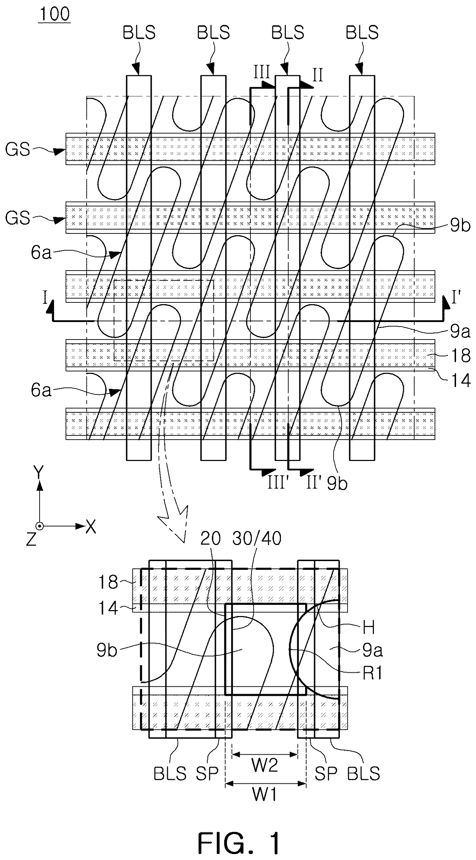

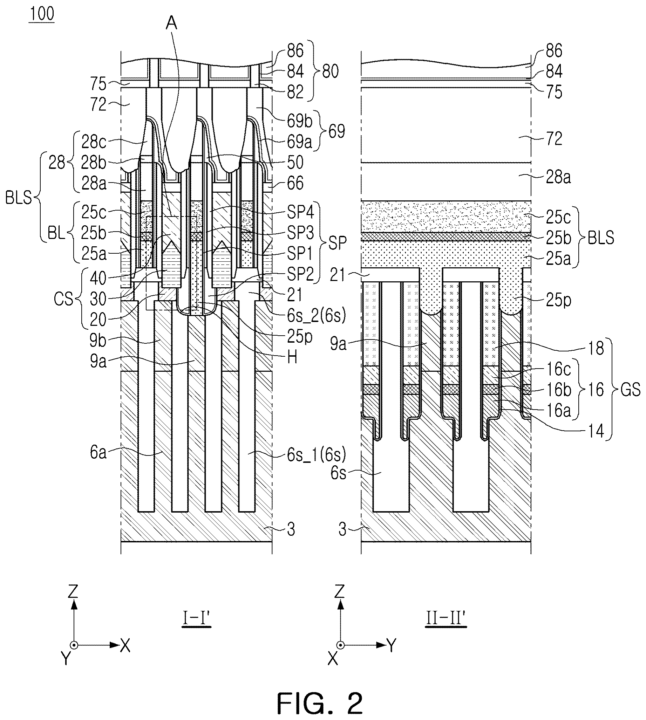

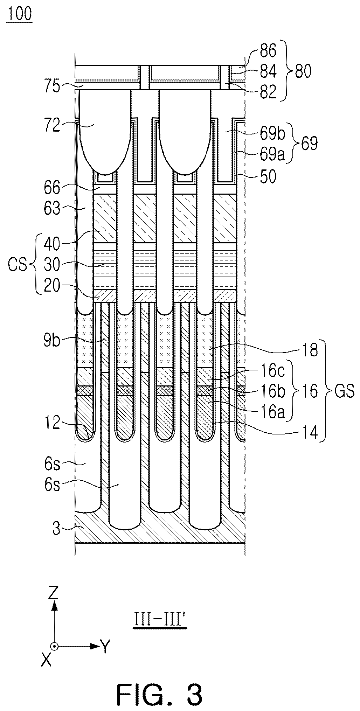

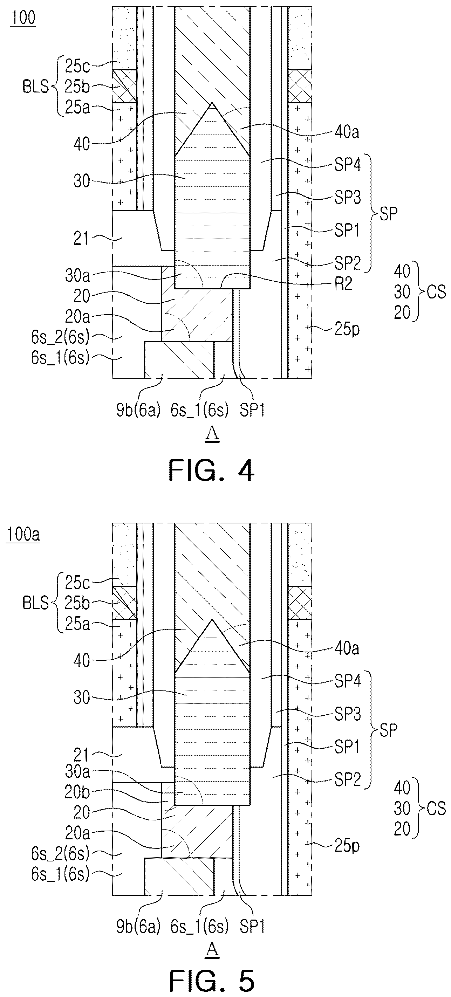

FIG. 1 is a plan view of a semiconductor device according to one or more embodiments. FIG. 2 is a vertical cross-sectional view taken along lines I-I' and II-II' of the semiconductor device illustrated in FIG. 1. FIG. 3 is a vertical cross-sectional view taken along lines III-III' of the semiconductor device illustrated in FIG. 1. FIG. 4 is an enlarged view of a portion of FIG. 2.

Referring to FIGS. 1 to 4, a semiconductor device 100 according to one or more embodiments may include an active region 6a, a device isolation layer 6s, a gate structure GS, a buffer layer 21, a bit line structure BLS, a spacer structure SP, a contact structure CS, a landing pad 69, and a capacitor structure 80. The semiconductor device 100 may be applied to, for example, a cell array of a Dynamic Random Access Memory (DRAM), but the disclosure is not limited thereto. The active region 6a and the gate structure GS may function as a memory cell transistor of the cell array.

The substrate 3 may include a semiconductor material, such as a group IV semiconductor, a group III-V compound semiconductor, or a group II-VI compound semiconductor. For example, the group IV semiconductor may include silicon, germanium, or silicon-germanium. The substrate 3 may be a silicon substrate, a silicon-on-insulator (SOI) substrate, a germanium substrate, a germanium-on-insulator (GOI) substrate, a silicon-germanium substrate, or a substrate including an epitaxial layer.

The active region 6a and the device isolation layer 6s may be disposed within the substrate 3. The device isolation layer 6s may be an insulating layer extending downward from the upper surface of the substrate 3 and may define the active region 6a. For example, the active region 6a may correspond to a portion of the upper surface of the substrate 3 surrounded by the device isolation layer 6s. In the plan view, the active region 6a may have a bar shape having a short axis and a long axis, and may extend in an inclined direction with respect to the X-direction and the Y-direction. However, the active region 6a may have other shapes, such as a pillar shape. Similarly, the active regions may be tapered in a vertical direction.

The active region 6a may include first and second impurity regions 9a and 9b extending from the upper surface thereof to a predetermined depth. The first and second impurity regions 9a and 9b may be spaced apart from each other. The first and second impurity regions 9a and 9b may be provided as source/drain regions of the memory cell transistor. For example, for one active region 6a, two gate structures GS may cross the one active region 6a, a drain region may be formed between the two gate structures GS, and source regions may be formed in regions opposite to the drain region for the two gate structures GS. For example, the first impurity region 9a may correspond to the drain region, and the second impurity region 9b may correspond to the source region. The source region and the drain region are formed by first and second impurity regions 9a and 9b by doping or ion implantation of substantially the same impurities, and may be referred to interchangeably depending on the circuit configuration of the transistor to be finally formed. The first and second impurity regions 9a and 9b may include impurities having a conductivity type opposite to a conductivity type of the substrate 3. For example, the active regions 6a may include p-type impurities, and the first and second impurity regions 9a and 9b may have n-type impurities.

The device isolation layer 6s may extend downward from the upper surface of the substrate 3 and may define active regions 6a. The device isolation layer 6s may separate the active regions 6a from each other while surrounding the active regions 6a. The device isolation layer 6s may include silicon oxide, silicon nitride, silicon oxynitride, or combinations thereof, and may be formed of a single layer or multiple layers.

In one or more embodiments, the device isolation layer 6s may include a lower portion 6s_1 and an upper portion 6s_2 on the lower portion 6s_1. The lower portion 6s_1 may refer to a portion of the device isolation layer 6s that is lower than the upper surface of the active region 6a in a vertical (Z) direction, and the upper portion 6s_2 may refer to a portion of the device isolation layer 6s that is higher than the upper surface of the active region 6a in the vertical direction. The upper portion 6s_2 may be in contact with the upper surface of the active region 6a. In one or more embodiments, the horizontal width along the X-direction of the upper portion 6s_2 may be greater than the horizontal width along the X-direction of the lower portion 6s_1, but the disclosure is not limited thereto.

In the plan view, the gate structures GS may extend in the X-direction and may be spaced apart from each other in the Y-direction. The transistors each including the gate structure GS and the first and second impurity regions 9a and 9b may form a buried channel array transistor (BCAT), but the disclosure is not limited thereto.

In the cross-sectional view, the gate structures GS may be buried in the substrate 3, and for example, the gate structures GS may be disposed within a gate trench 12 formed in the substrate 3. The gate structure GS may include a gate dielectric layer 14, a gate electrode 16, and a gate capping layer 18 disposed within the gate trench 12. The gate dielectric layer 14 may be conformally formed on the inner wall of the gate trench 12. The gate electrode 16 may be disposed on the lower portion of the gate trench 12, and the gate capping layer 18 may be disposed on the upper portion of the gate structure GS and may fill the gate trench 12.

The gate dielectric layer 14 may include silicon oxide or a material having a high dielectric constant. A high dielectric constant means higher than silicon oxide. In one or more embodiments, the gate dielectric layer 14 may be a layer formed by oxidizing the first active region 6a or a layer formed by deposition. The gate electrode 16 may include a first electrode layer 16a, a second electrode layer 16b, and a third electrode layer 16c that are sequentially laminated.

The first electrode layer 16a may include at least one of titanium (Ti), titanium nitride (TiN), tantalum (Ta), tantalum nitride (TaN), tungsten (W), tungsten nitride (WN), and aluminum (Al). In one or more embodiments, the first electrode layer 16a may include titanium nitride (TiN). The second electrode layer 16b may include cobalt silicide (CoSi), titanium silicide (TiSi), nickel silicide (NiSi), tungsten silicide (WSi), or other metal silicides. The third electrode layer 16c may include polysilicon. The gate capping layer 18 may include silicon nitride.

The buffer layer 21 may be disposed on the active region 6a, the device isolation layer 6s, and the gate structure GS and may extend in a horizontal direction. The buffer layer 21 may be in contact with the upper surface of the device isolation layer 6s. For example, the lower surface of the buffer layer 21 may be in contact with the upper portion 6s_2 of the device isolation layer 6s. The buffer layer 21 may be in contact with the gate structure GS. For example, the lower surface of the buffer layer 21 may be in contact with the gate dielectric layer 14 and the gate capping layer 18. The buffer layer 21 may include silicon oxide, silicon nitride, silicon oxynitride, or combinations thereof. The buffer layer 21 may be composed of a single layer or multiple layers.

The bit line structures BLS extend in the Y-direction and may be spaced apart from each other in the X-direction. The bit line structures BLS may have a bar shape extending in the Y-direction. The bit line structures BLS may include a bit line BL and a bit line capping layer 28 on the bit line BL. The bit line BL may include a first conductive layer 25a, a second conductive layer 25b, and a third conductive layer 25c that are sequentially laminated on a buffer layer 21. The first conductive layer 25a may include polysilicon. The second conductive layer 25b may include a metal-semiconductor compound. The metal-semiconductor compound may be, for example, a layer in which a portion of the first conductive layer 25a is silicidated. For example, the metal-semiconductor compound may include cobalt silicide (CoSi), titanium silicide (TiSi), nickel silicide (NiSi), tungsten silicide (WSi), or other metal silicides, or may include a nitride such as TiSiN. The third conductive layer 25c may include a metal material such as titanium (Ti), tantalum (Ta), tungsten (W), and aluminum (Al). The bit line BL may further include a bit line contact 25p that is disposed below the first conductive layer 25a and extends downward to contact a first impurity region 9a. The bit line contact 25p may be located within a contact hole H formed on an upper surface of the substrate 3. In a plan view, the bit line contact 25p may contact the first impurity region 9a, which is a central portion of the active region 6a. The bit line contact 25p may electrically connect the active region 6a to the bit line structure BLS. The bit line contact 25p may include the same material as the first conductive layer 25a and may be formed integrally with the first conductive layer 25a.

The bit line capping layer 28 may include a first capping layer 28a, a second capping layer 28b, and a third capping layer 28c disposed on the bit line BL. The side surface of the first capping layer 28a may be coplanar with the first conductive layer 25a, the second conductive layer 25b, and the third conductive layer 25c. The first capping layer 28a, the second capping layer 28b, and the third capping layer 28c may include silicon oxide, silicon nitride, silicon oxynitride, or combinations thereof, and may include, for example, silicon nitride.

The spacer structures SP may be disposed on both sides of the bit line structures BLS, respectively, and may extend in the Y-direction along the side surfaces of the bit line structures BLS. The spacer structure SP may include a first spacer SP1, a second spacer SP2, a third spacer SP3, and a fourth spacer SP4 disposed on the side surfaces of the bit line structures BLS. The first spacer SP1 may be conformally disposed along the side surfaces of the bit line structures BLS and the contact hole H. The second spacer SP2 may be disposed on the first spacer SP1 and may fill the contact hole H. The third spacer SP3 may cover the side surface of the first spacer SP1, and the fourth spacer SP4 may cover the side surface of the third spacer SP3. The third spacer SP3 and the fourth spacer SP4 may cover the upper surface of the second spacer SP2. The first spacer SP1, the second spacer SP2, the third spacer SP3, and the fourth spacer SP4 may include silicon oxide, silicon nitride, silicon oxynitride, or combinations thereof. The spacer structure SP of the present disclosure is illustrative, and the number of materials and layers is not limited thereto and may be variously changed.

The contact structure CS may be disposed between the bit line structures BLS and may be in contact with the spacer structures SP. The contact structures CS may be disposed between the bit line structures BLS and between the gate structures GS. The contact structures CS may electrically connect the active regions 6a to the landing pads 69.

The contact structure CS may include a first contact plug 20, a second contact plug 30, and a third contact plug 40 that are sequentially stacked. The first contact plug 20 may be in contact with an upper surface of an active region 6a. For example, a lower surface of the first contact plug 20 may be coplanar with an upper surface of a second impurity region 9b and may be electrically connected to the second impurity region 9b. In cross-sectional view, the first contact plug 20 may be disposed to be offset from the second impurity region 9b in the X-direction. For example, side surfaces of the first contact plug 20 may be offset from side surfaces of the second impurity region 9b in the X-direction, and a portion of the first contact plug 20 may be disposed to be offset from the second impurity region 9b in the X-direction without vertically overlapping with the second impurity region 9b. In the cross-sectional view, the vertical center axis of the second impurity region 9b may be disposed to be offset from the vertical center axis of the first contact plug 20 in the X-direction without being aligned therewith. The first contact plug 20 may be in contact with the device isolation layer 6s. For example, a lower surface of the first contact plug 20 may be in contact with a lower portion 6s_1 of the device isolation layer 6s, and a side surface of the first contact plug 20 may be in contact with an upper portion 6s_2 of the device isolation layer 6s. An upper surface of the first contact plug 20 may be in contact with the buffer layer 21 and may be coplanar with the upper portion 6s_2 of the device isolation layer 6s. In the plan view, the side surface of the first contact plug 20 may include a recess R1. The recess R1 may correspond to a portion of the contact hole H. The recess R1 may be in contact with the first spacer SP1 of the spacer structure SP.

Referring to FIG. 1, in the plan view, the maximum horizontal width W1 of the first contact plug 20 along the X-direction may be larger than the maximum horizontal width W2 of the second contact plug 30 along the X-direction. The maximum horizontal width W2 of the third contact plug 40 along the X-direction may be the same as the maximum horizontal width W2 of the second contact plug 30 along the X-direction. The horizontal width of the first contact plug 20 along the Y-direction may be the same as the horizontal width of the second contact plug 30 along the Y-direction and the horizontal width of the third contact plug 40 along the Y-direction.

The second contact plug 30 may be in contact with the first contact plug 20 on the first contact plug 20. In one or more embodiments, the upper surface of the first contact plug 20 may include a recess R2, and a portion of a side surface and a portion of a lower surface of the second contact plug 30 may be in contact with the recess R2. The lower surface of the second contact plug 30 may be disposed at a level lower than the top of the first contact plug 20 and the upper surface of the upper portion 6s_2 of the device isolation layer 6s. The second contact plug 30 may be in contact with the buffer layer 21 and the spacer structure SP. In one or more embodiments, the second contact plug 30 may be offset from the first contact plug 20 in the X-direction. For example, a portion of the second contact plug 30 may not vertically overlap with the first contact plug 20. In the cross-sectional view, the vertical center axis of the second contact plug 30 may be disposed to be offset from the vertical center axis of the first contact plug 20 in the X-direction without being aligned therewith. In one or more embodiments, the upper surface of the second contact plug 30 may not be parallel to the upper surface of the substrate 3 and may be tilted with respect to the upper surface of the substrate 3.

The third contact plug 40 may be in contact with the second contact plug 30 on the second contact plug 30. The third contact plug 40 may be in contact with the spacer structures SP. The horizontal width of the third contact plug 40 along the X-direction may be the same as the horizontal width of the second contact plug 30 along the X-direction. The horizontal width of the third contact plug 40 along the Y-direction may be the same as the horizontal width of the second contact plug 30 along the Y-direction. In the cross-sectional view, the vertical center axis of the third contact plug 40 may be aligned with the vertical center axis of the second contact plug 30 in the X-direction. The bottom of the third contact plug 40 may be disposed at a level higher than the upper surface of the active region 6a and the upper surface of the buffer layer 21, and may be disposed at a level higher than the bit line contact 25p.

The first contact plug 20, the second contact plug 30, and the third contact plug 40 may be made of a conductive material, and may include, for example, at least one of polysilicon (Si), titanium (Ti), titanium nitride (TiN), tantalum (Ta), tantalum nitride (TaN), tungsten (W), tungsten nitride (WN), and aluminum (Al). In one or more embodiments, the first contact plug 20, the second contact plug 30, and the third contact plug 40 may include at least one of doped single crystal silicon and doped polysilicon, and may include n-type impurities such as phosphorus (P), arsenic (As), and antimony (Sb).

In one or more embodiments, the first contact plug 20 may be formed from the second impurity region 9b of the active region 6a by a selective epitaxial growth (SEG) method. In one or more embodiments, the crystal orientation of a portion of the first contact plug 20 may be different from the crystal orientation of the second impurity region 9b. For example, the first contact plug 20 may include a region 20a having a crystal orientation different from the crystal orientation of the second impurity region 9b. The crystal orientation of the first contact plug 20 excluding the region 20a may be the same as the crystal orientation of the second impurity region 9b. The doping concentration of the first contact plug 20 may be greater than the doping concentration of the second impurity region 9b.

In one or more embodiments, the second contact plug 30 may be formed from the first contact plug 20 by a selective epitaxy growth method. In one or more embodiments, the crystal orientation of a portion of the second contact plug 30 may be different from the crystal orientation of the first contact plug 20. For example, the second contact plug 30 may include a region 30a having a different crystal orientation from the crystal orientation of the first contact plug 20. The crystal orientation of the second contact plug 30 excluding the region 30a may be the same as the crystal orientation of the first contact plug 20 (for example, a portion excluding the region 20a). The doping concentration of the second contact plug 30 may be greater than the doping concentration of the first contact plug 20.

In one or more embodiments, the third contact plug 40 may be formed by depositing polysilicon on the second contact plug 30 and then annealing the polysilicon. In one or more embodiments, the crystal orientation of a portion of the third contact plug 40 may be different from the crystal orientation of the second contact plug 30. For example, the third contact plug 40 may include a region 40a having a different crystal orientation from the crystal orientation of the second contact plug 30. The crystal orientation of the third contact plug 40 excluding the region 40a may be the same as the crystal orientation of the second contact plug 30 (for example, a portion excluding the region 30a). The doping concentration of the third contact plug 40 may be greater than the doping concentration of the second contact plug 30. The shape, size, and position of the regions 20a, 30a and 40a are illustrative and are not limited thereto.

The fence structures 63 may be disposed between the bit line structures BLS and may overlap the gate structure GS in a vertical direction. The fence structures 63 may be disposed alternately with the contact structures CS along the Y-direction. The fence structures 63 may spatially separate the contact structures CS from each other and electrically insulate each other. The lower surface of the fence structures 63 may be in contact with the gate capping layer 18 of the gate structure GS. In one or more embodiments, the bottom of the fence structures 63 may be located at a level lower than the upper surface of the substrate 3. The fence structures 63 may include an insulating material, for example, silicon nitride.

The semiconductor device 100 may further include a metal-semiconductor compound layer 66 disposed on the upper surface of the contact structure CS. The metal-semiconductor compound layer 66 may be in contact with the side surface of the spacer structure SP and the side surface of the fence structure 63.

The landing pad 69 may be disposed on the metal-semiconductor compound layer 66 and may include a barrier layer 69a covering the bit line structure BLS, the spacer structure SP and the fence structure 63 and a metal layer 69b on the barrier layer 69a. The landing pad 69 may be electrically connected to the second impurity region 9b of the active region 6a through the contact structure CS. The metal-semiconductor compound layer 66 may include cobalt silicide (CoSi), titanium silicide (TiSi), nickel silicide (NiSi), tungsten silicide (WSi), or other metal silicides. The barrier layer 69a may include at least one of a metal nitride, for example, titanium nitride (TiN), tantalum nitride (TaN), and tungsten nitride (WN). The metal layer 69b may include at least one of a conductive material, for example, titanium (Ti), tantalum (Ta), tungsten (W), and aluminum (Al).

The semiconductor device 100 may further include an upper insulating spacer 50 covering the upper portions of the bit line structure BLS, the spacer structure SP, and the fence structure 63. The upper insulating spacer 50 may be disposed between the bit line structure BLS and the barrier layer 69a, between the spacer structure SP and the barrier layer 69a, and between the fence structure 63 and the barrier layer 69a.

The semiconductor device 100 may further include an insulating pattern 72 disposed between the landing pads 69. The upper surface of the insulating pattern 72 may be coplanar with the upper surface of the landing pad 69, and the insulating pattern 72 may extend downward to partially contact the bit line structures BLS. The insulating pattern 72 may spatially separate the landing pads 69 from each other and electrically insulate the landing pads from each other.

The semiconductor device 100 may further include an etch stop layer 75 covering the upper surface of the landing pad 69 and the insulating pattern 72. A capacitor structure 80 may be disposed on the landing pad 69 and the insulating pattern 72. The capacitor structure 80 may include a lower electrode 82, a capacitor dielectric layer 84, and an upper electrode 86. The lower electrode 82 may penetrate the etch stop layer 75 and contact the upper surface of the landing pad 69. A capacitor dielectric layer 84 may cover the lower electrode 82 and the etch stop layer 75, and an upper electrode 86 may cover the capacitor dielectric layer 84. The capacitor structure 80 may be electrically connected to the landing pad 69 and the contact structure CS. The lower electrode 82 and the upper electrode 86 may include at least one of a doped semiconductor, a metal nitride, a metal, and a metal oxide. The lower electrode 82 and the upper electrode 86 may include at least one of, for example, polycrystalline silicon, titanium nitride (TiN), tungsten (W), titanium (Ti), ruthenium (Ru), and tungsten nitride (WN). The capacitor dielectric layer 84 may include at least one of high-κ materials such as zirconium oxide (ZrO₂), aluminum oxide (Al₂O₃), and hafnium oxide (Hf₂O₃), for example.

FIGS. 5 to 7 are vertical cross-sectional views of semiconductor devices according to one or more embodiments.

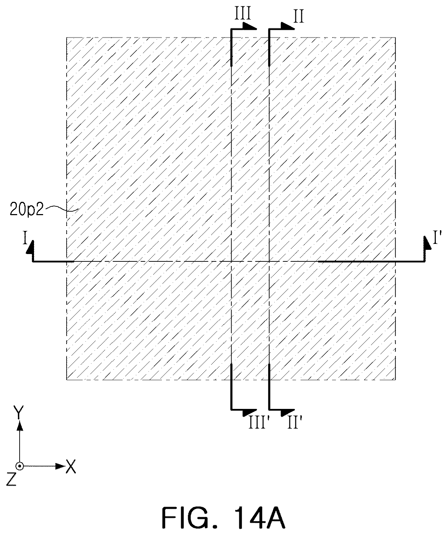

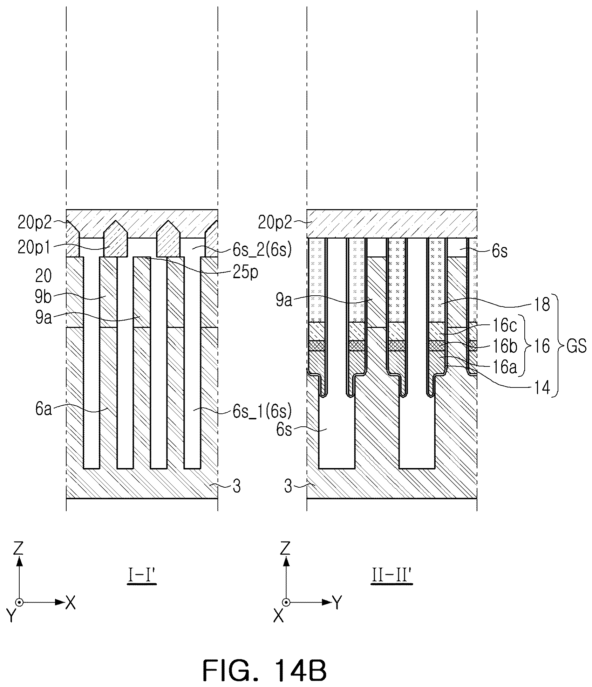

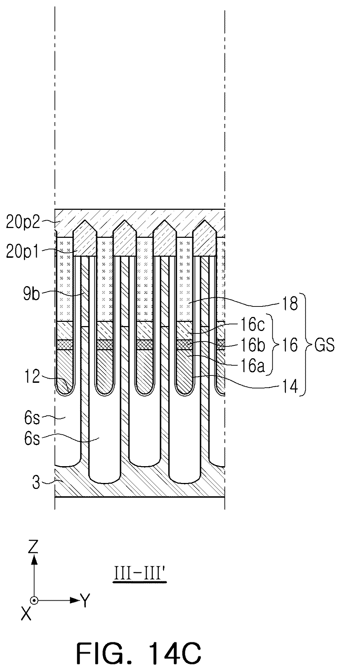

Referring to FIG. 5, a semiconductor device 100a may include a first contact plug 20 between a second impurity region 9b and a second contact plug 30. In one or more embodiments, the first contact plug 20 may include regions having different crystal orientations. For example, the first contact plug 20 may include a region 20b. The region 20b may include a second contact material layer 20p2, which will be described later with reference to FIGS. 14A to 14C. The crystal orientation of the region 20b may be different from the crystal orientation of the first contact plug 20 except for the regions 20a and 20b.

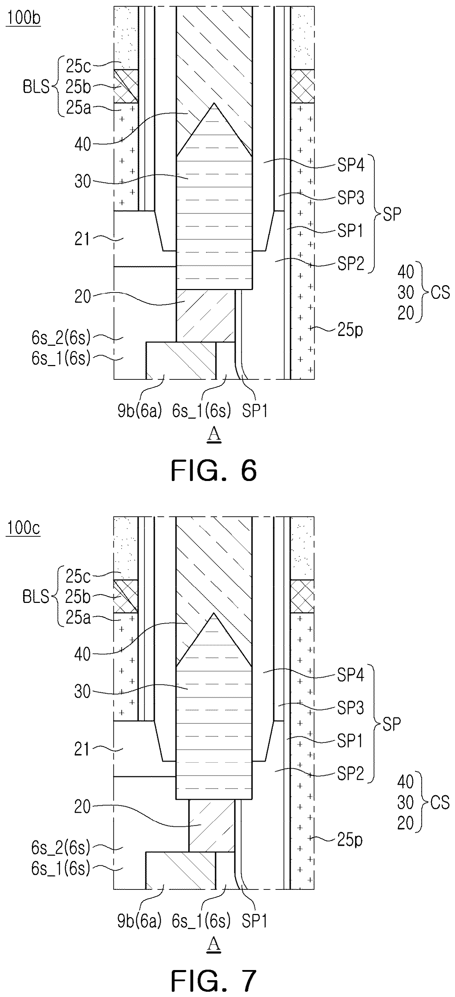

Referring to FIG. 6, a semiconductor device 100b may include a first contact plug 20 between the second impurity region 9b and the second contact plug 30. In one or more embodiments, the side surface of the first contact plug 20 in contact with the upper portion 6s_2 of the device isolation layer 6s may be coplanar with the second contact plug 30. The side surface of the second contact plug 30 may be in contact with the upper portion 6s_2 of the device isolation layer 6s.

Referring to FIG. 7, a semiconductor device 100c may include a first contact plug 20 between the second impurity region 9b and the second contact plug 30. In one or more embodiments, the width of the first contact plug 20 along the X-direction may be smaller than the width of the second contact plug 30 along the X-direction. For example, the first contact plug 20 may completely overlap with the second contact plug 30 in the vertical direction, and a portion of the second contact plug 30 may not overlap with the first contact plug 20 in the vertical direction. The side surface of the second contact plug 30 may be in contact with the upper portion 6s_2 of the device isolation layer 6s.

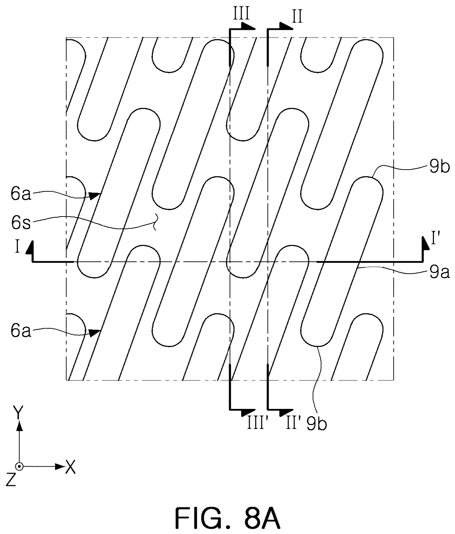

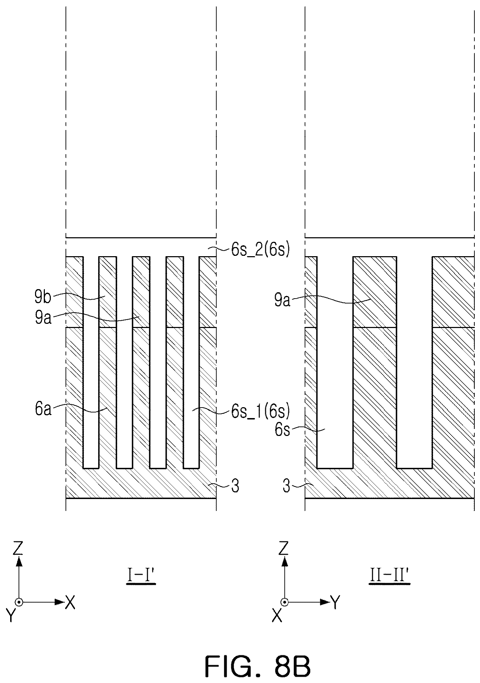

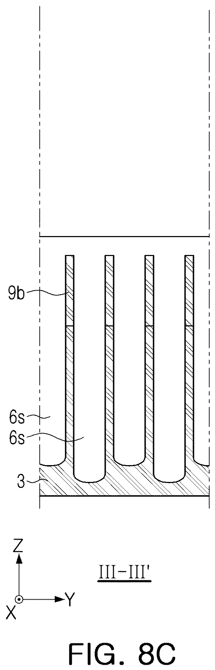

FIGS. 8A to 18C are plan views and vertical cross-sectional views illustrating a method of manufacturing a semiconductor device according to one or more embodiments in accordance with a process sequence. Specifically, FIGS. 8A, 9A, 10A, 11A, 13A, 14A, 15A, 16A, 17A, and 18A are plan views illustrating the process sequence illustrating a method of manufacturing a semiconductor device. FIGS. 8B, 9B, 10B, 11B, 13B, 14B, 15B, 16B, 17B, and 18B are vertical cross-sectional views along lines I-I' and II-II' of FIGS. 8A, 9A, 10A, 11A, 13A, 14A, 15A, 16A, 17A, and 18A, respectively. FIG. 8C, FIG. 9C, FIG. 10C, FIG. 13C, FIG. 14C, FIG. 15C, FIG. 16C, FIG. 17C and FIG. 18C are vertical cross-sectional views taken along line III-III' of FIG. 8A, FIG. 9A, FIG. 10A, FIG. 13A, FIG. 14A, FIG. 15A, FIG. 16A, FIG. 17A and FIG. 18A, respectively.

Referring to FIGS. 8A to 8C, a device isolation layer 6s may be formed on a substrate 3. The device isolation layer 6s may define active regions 6a. A portion of the device isolation layer 6s disposed between four adjacent active regions 6a may be formed relatively deeper than a portion of the device isolation layer 6s disposed between two adjacent active regions 6a. The device isolation layer 6s may be formed by forming a trench on the upper surface of the substrate 3 and depositing an insulating material to fill the trench. The device isolation layer 6s may cover the upper surfaces of the active regions 6a. A portion of the device isolation layer 6s that is lower than the upper surface of the active region 6a may be referred to as a lower portion 6s_1, and a portion of the device isolation layer 6s that is higher than the upper surface of the active region 6a may be referred to as an upper portion 6s_2.

The active region 6a may include a first impurity region 9a and a second impurity region 9b. The first impurity region 9a and the second impurity region 9b may be formed by doping the active region 6a with an n-type impurity. For example, after the device isolation layer 6s is formed, the first impurity region 9a and the second impurity region 9b may be formed by a doping process.

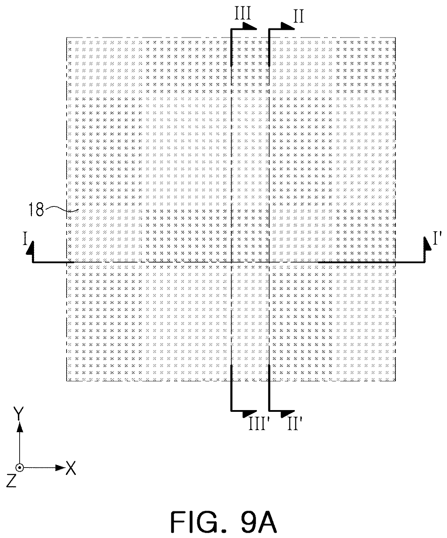

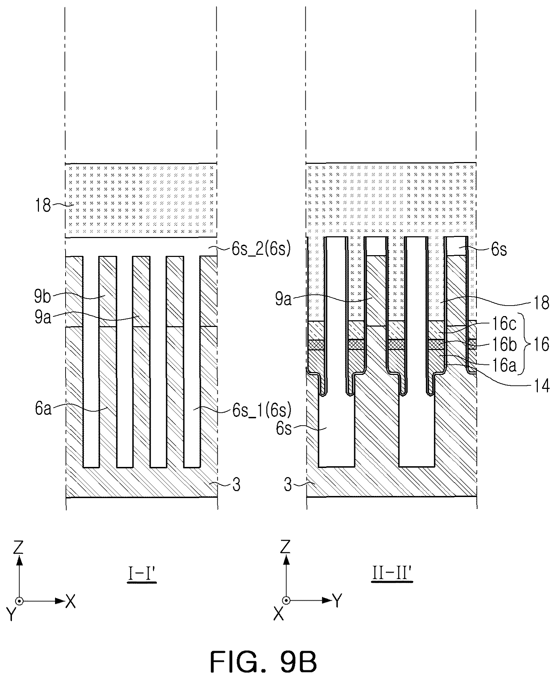

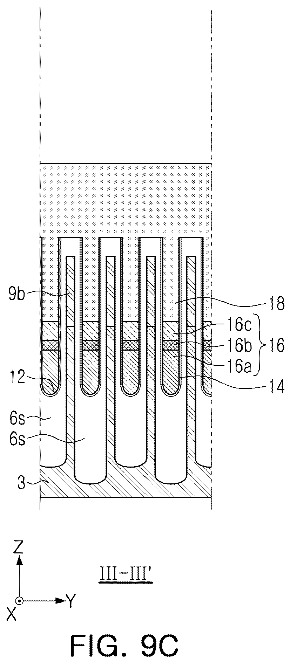

Referring to FIGS. 9A to 9C, gate trenches 12 that cross the device isolation layer 6s and active regions 6a within the substrate 3 may be formed. The gate trenches 12 may be formed by an anisotropic etching process. The gate trenches 12 may extend in the X-direction and may be spaced apart from each other in the Y-direction. The active region 6a and the device isolation layer 6s may be etched by the etching process. A gate dielectric layer 14 may be formed on the gate trench 12. The gate dielectric layer 14 may be formed conformally along the inner wall of the gate trench 12 and may be in contact with the active region 6a and the device isolation layer 6s.

A first electrode layer 16a, a second electrode layer 16b, and a third electrode layer 16c may be sequentially formed on the gate dielectric layer 14 within the gate trench 12. The first electrode layer 16a, the second electrode layer 16b, and the third electrode layer 16c may form the gate electrode 16. The gate capping layer 18 may be formed on the third electrode layer 16c and may completely fill the gate trench 12. The gate capping layer 18 may be formed to cover the device isolation layer 6s and may include a material having an etching selectivity with respect to the device isolation layer 6s.

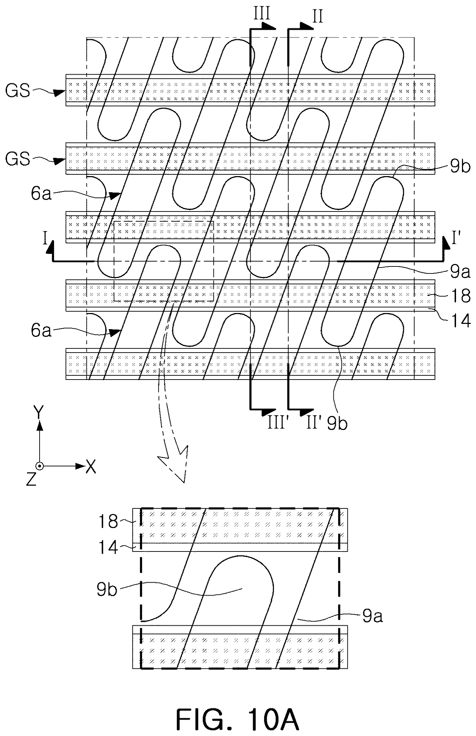

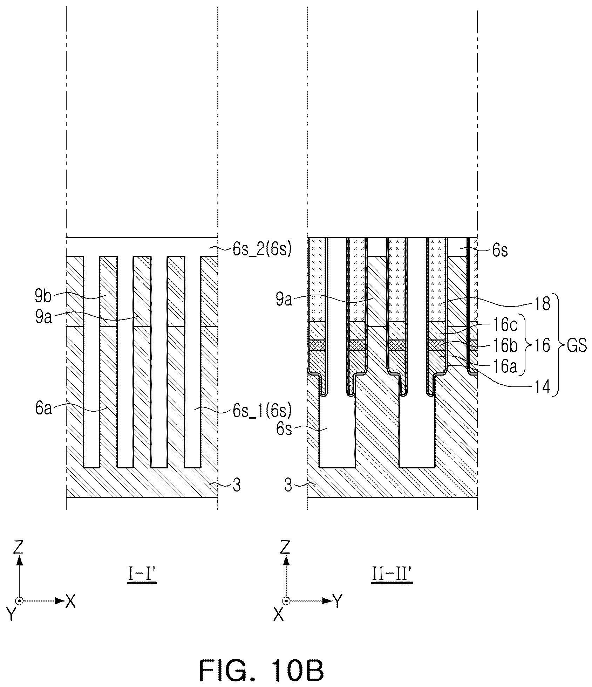

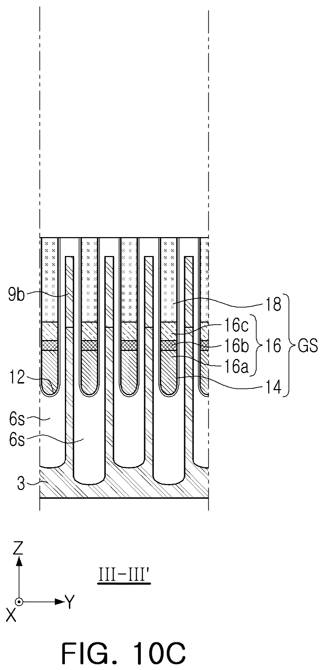

Referring to FIGS. 10A to 10C, an upper portion of the gate capping layer 18 may be removed by a planarization process. The upper surface of the planarized gate capping layer 18 may be coplanar with the device isolation layer 6s and the gate dielectric layer 14. The gate dielectric layer 14, the gate electrode 16, and the gate capping layer 18 may form a gate structure GS. The gate structures GS may extend in the X-direction across the device isolation layer 6s and the active regions 6a and may be spaced apart from each other in the Y-direction.

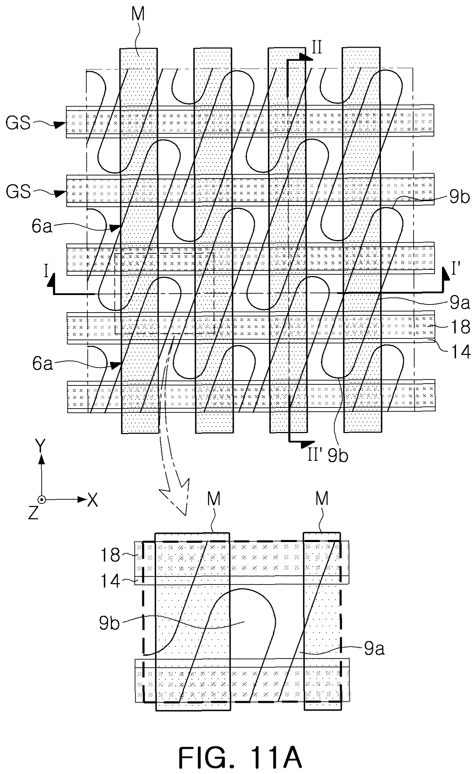

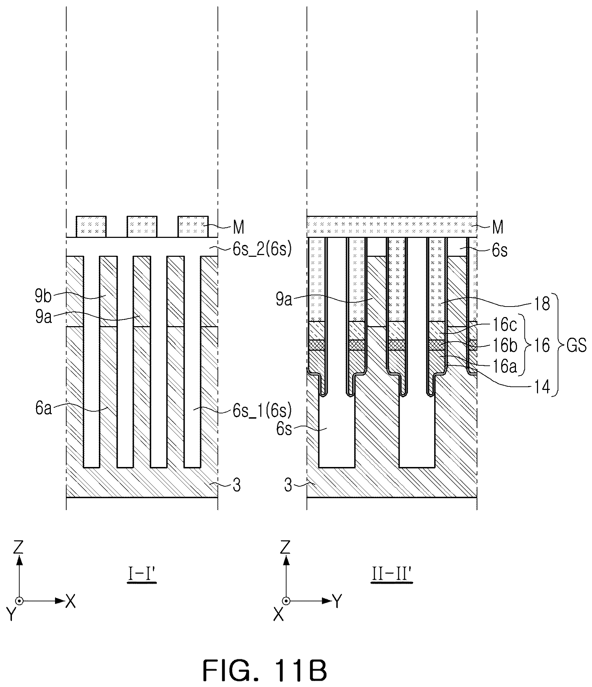

Referring to FIGS. 11A and 11B, mask layers M may be formed. The mask layers M may extend in the Y-direction and may be spaced apart from each other in the X-direction. The mask layers M may be disposed to overlap the first impurity regions 9a of the active regions 6a. For example, at least a portion of the first impurity regions 9a of the active regions 6a may vertically overlap with the mask layers M.

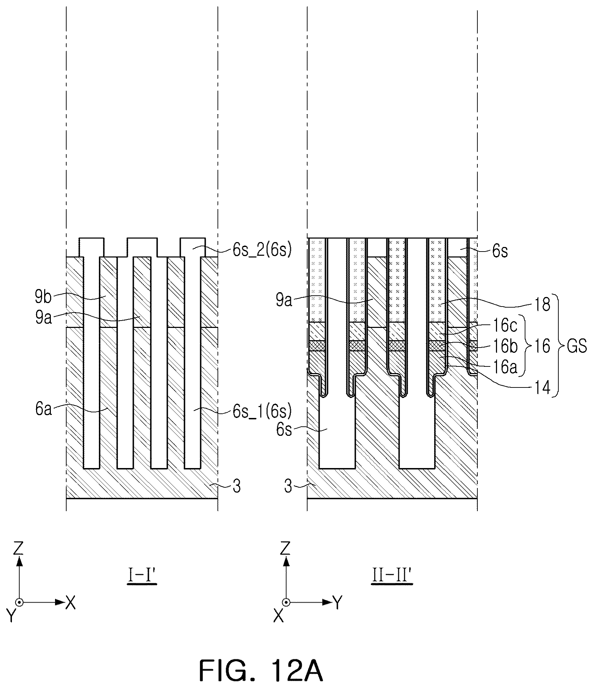

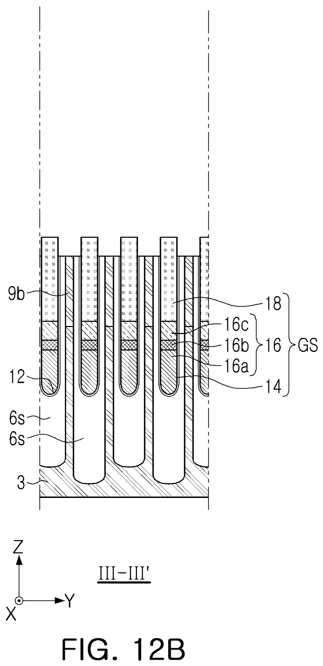

Referring to FIGS. 12A and 12B, the device isolation layer 6s may be etched by an etching process using the mask layers M as an etching mask, and the second impurity regions 9b of the active regions 6a may be exposed. In one or more embodiments, respective upper surfaces of the second impurity regions 9b may be partially exposed and may not be completely exposed.

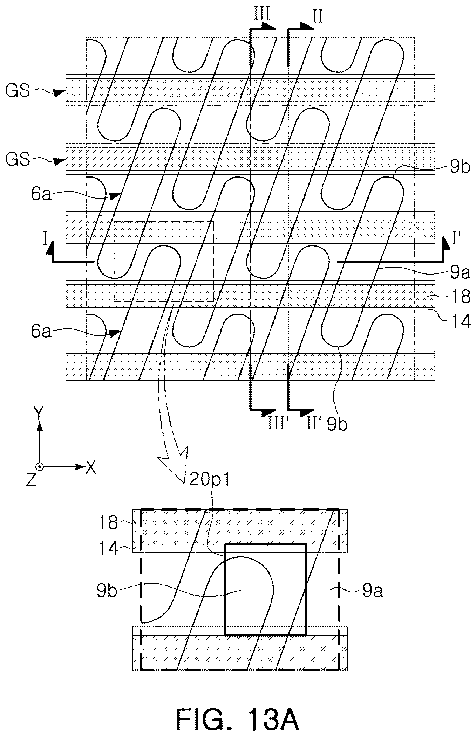

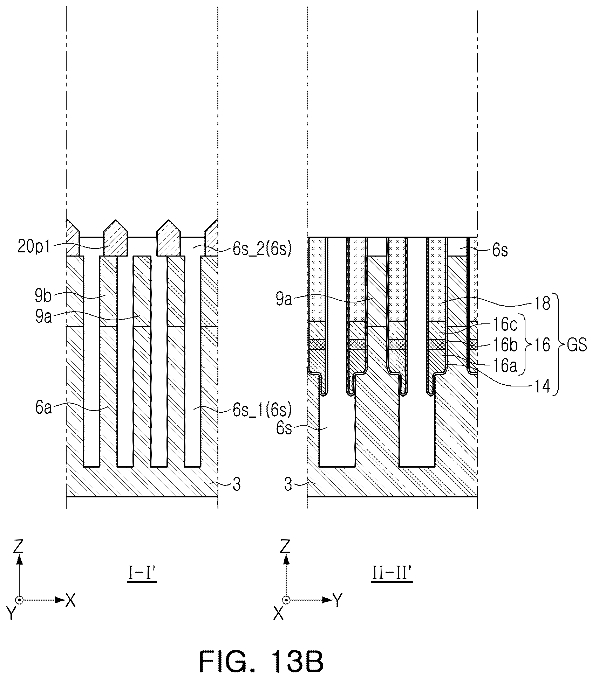

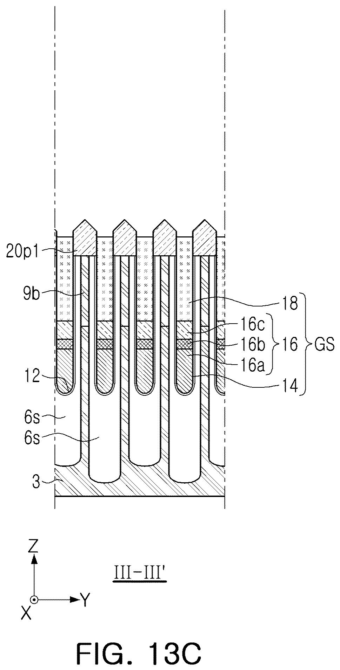

Referring to FIGS. 13A to 13C, the first contact material layers 20p1 may be formed. In one or more embodiments, the first contact material layers 20p1 may be formed by growing from the upper surfaces of the second impurity regions 9b of the active regions 6a by a selective epitaxial growth method. The first contact material layers 20p1 may include at least one of doped single crystal silicon and doped polysilicon. For example, the first contact material layers 20p1 are grown from the second impurity regions 9b which are formed of single crystal silicon, and may thus include single crystal silicon having the same crystal orientation as the second impurity regions 9b. According to one or more embodiments, a portion of the first contact material layers 20p1 may include doped polysilicon or single crystal silicon having a different crystal orientation from the second impurity regions 9b. The first contact material layers 20p1 may include n-type impurities, and the doping concentration of the first contact material layers 20p1 may be greater than the doping concentration of the second impurity regions 9b.

The first contact material layers 20p1 may be grown in the horizontal and vertical directions to cover the lower portions 6s_1 of the device isolation layer 6s so that the lower portions 6s_1 of the device isolation layer 6s are not exposed. The tops of the first contact material layers 20p1 may be formed higher than the upper portions 6s_2 of the device isolation layer 6s.

Referring to FIGS. 14A to 14C, the second contact material layer 20p2 may be formed on the first contact material layers 20p1. The second contact material layer 20p2 may extend in a horizontal direction and completely cover the device isolation layer 6s, the gate structures GS, and the first contact material layers 20p1. The second contact material layer 20p2 may be formed by depositing polysilicon, and at least a portion of the second contact material layer 20p2 may include single crystal silicon that is crystallized and has the same crystal orientation as the first contact material layers 20p1. According to one or more embodiments, a portion of the second contact material layer 20p2 may include doped polysilicon or may include single crystal silicon that has a different crystal orientation from the first contact material layers 20p1.

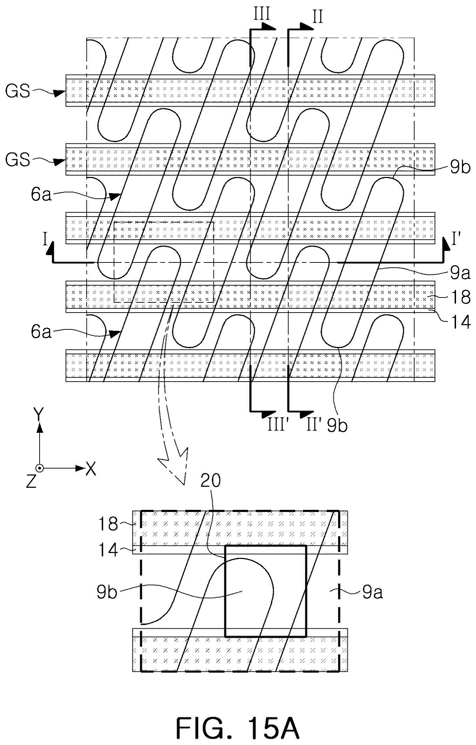

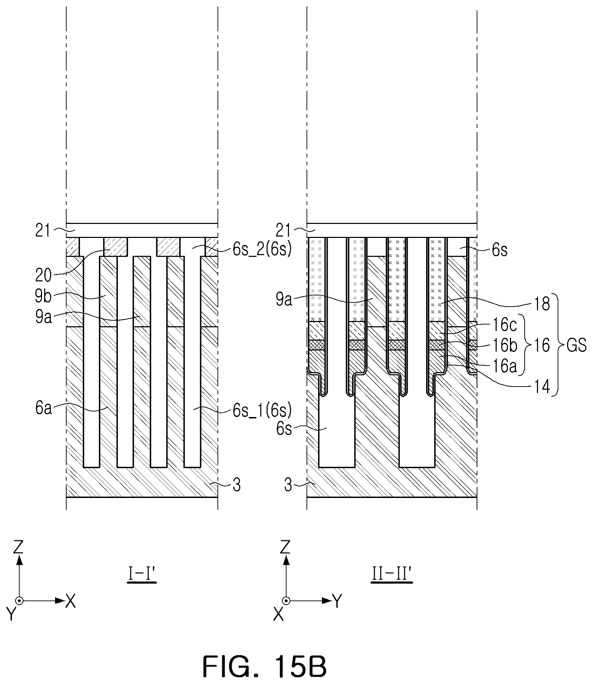

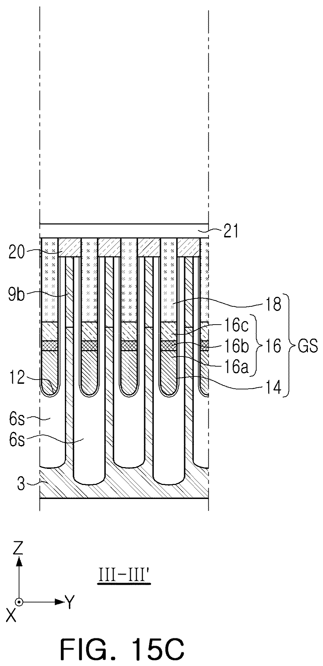

Referring to FIGS. 15A to 15C, the first contact material layers 20p1 and the second contact material layers 20p2 may be planarized so that the upper surface of the device isolation layer 6s and the upper surface of the gate structure GS are exposed, thereby forming a first contact plug 20. In one or more embodiments, the second contact material layer 20p2 may be completely removed, and the first contact material layers 20p1 may be planarized, thereby forming the first contact plug 20. In one or more embodiments, the second contact material layer 20p2 may not be completely removed, and may form the first contact plug 20 together with the first contact material layers 20p1. For example, in the process of forming the first contact material layer 20p1 described with reference to FIGS. 13A to 13C, if the first contact material layer 20p1 is not sufficiently grown to cover the side surface of the upper portion 6s_2 of the device isolation layer 6s, the second contact material layer 20p2 may be interposed between the first contact material layer 20p1 and the upper portion 6s_2 of the device isolation layer 6s (see FIG. 5).

The upper surface of the first contact plug 20 may be coplanar with the device isolation layer 6s and the gate structure GS. A buffer layer 21 may be formed on the device isolation layer 6s, the first contact plug 20, and the gate structure GS. The buffer layer 21 may extend in a horizontal direction and may be composed of a single layer or multiple layers.

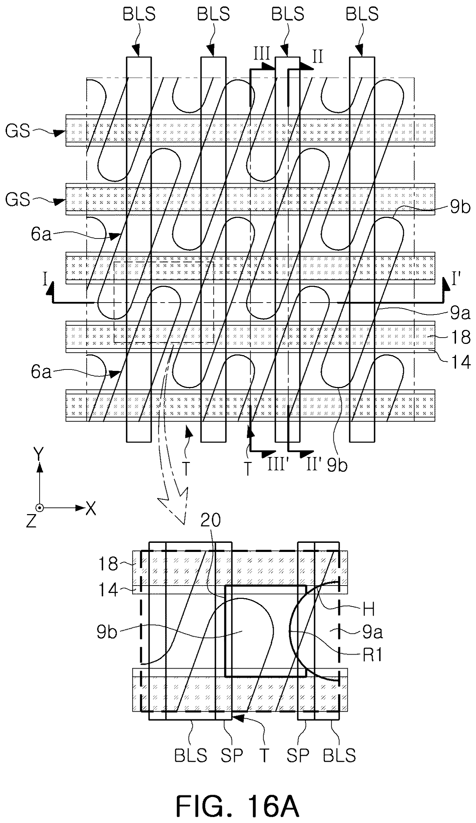

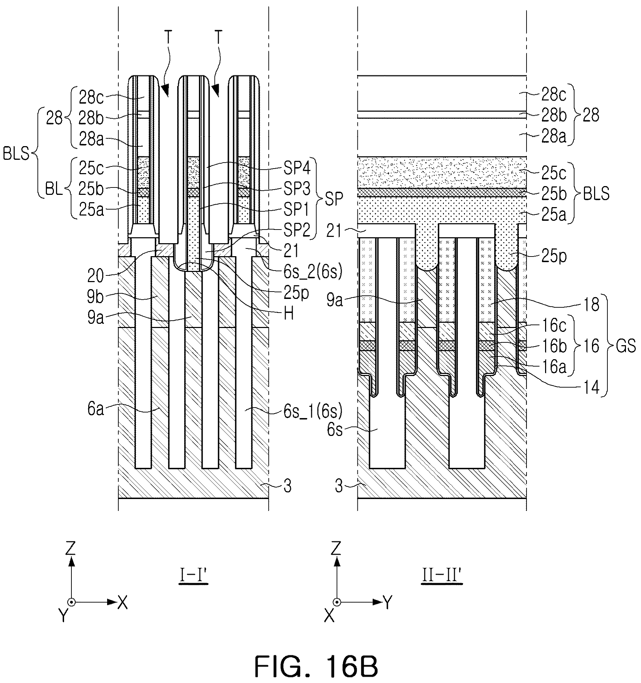

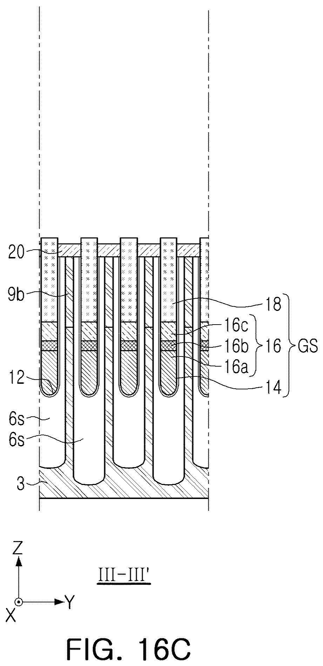

Referring to FIGS. 16A to 16C, a bit line structure BLS may be formed on a buffer layer 21. The bit line structure BLS may be formed by etching the buffer layer 21 so that a first impurity region 9a of an active region 6a is exposed to form a contact hole H, stacking conductive material layers on the contact hole H and the buffer layer 21, forming insulating material layers on the conductive material layers, and patterning the conductive material layers and the insulating material layers. For example, the patterned conductive material layers and insulating material layers may extend in the Y-direction and form the bit line structure BLS. An inner wall of the contact hole H may be partially exposed by the patterning process. The bit line structures BLS may extend in the Y-direction and may be spaced apart from each other in the X-direction. In one or more embodiments, when forming the contact hole H, the first contact plug 20 may be partially etched, and when viewed in a plan view, the first contact plug 20 may include a recess R1 on a side surface.

The bit line structure BLS may include a bit line contact 25p including a conductive material, a bit line BL, and a bit line capping layer 28 including an insulating material. The bit line BL may include a first conductive layer 25a, a second conductive layer 25b, and a third conductive layer 25c that are sequentially stacked, and the first conductive layer 25a may be disposed on the bit line contact 25p that is disposed within the contact hole H. The bit line capping layer 28 may include a first capping layer 28a, a second capping layer 28b, and a third capping layer 28c that are sequentially stacked.

A spacer structure SP may be formed on a side surface of a bit line structure BLS. The spacer structure SP may extend in the Y-direction along the bit line structure BLS. The spacer structure SP may include a first spacer SP1, a second spacer SP2, a third spacer SP3, and a fourth spacer SP4. The first spacer SP1 may be conformally formed along a side surface of the bit line structure BLS and a contact hole H. The second spacer SP2 may be disposed on the first spacer SP1 and may fill the contact hole H. The third spacer SP3 may cover the side surface of the first spacer SP1, and the fourth spacer SP4 may cover the side surface of the third spacer SP3.

After the spacer structures SP are formed, an anisotropic etching process may be performed to expose the first contact plug 20, thereby forming trenches T. The buffer layer 21 may be etched by the etching process, and the first contact plug 20 may also be partially etched. The trench T may be defined by the side surface of the spacer structures SP, the side surface of the buffer layer 21, and the upper surface of the first contact plug 20. Since the trench T is formed to expose the first contact plug 20, the trench T may be relatively shallow compared to a case where the trench is formed to expose the second impurity region 9b. Therefore, the difficulty of the anisotropic etching process may be reduced, and a more miniaturized semiconductor device 100 may be implemented.

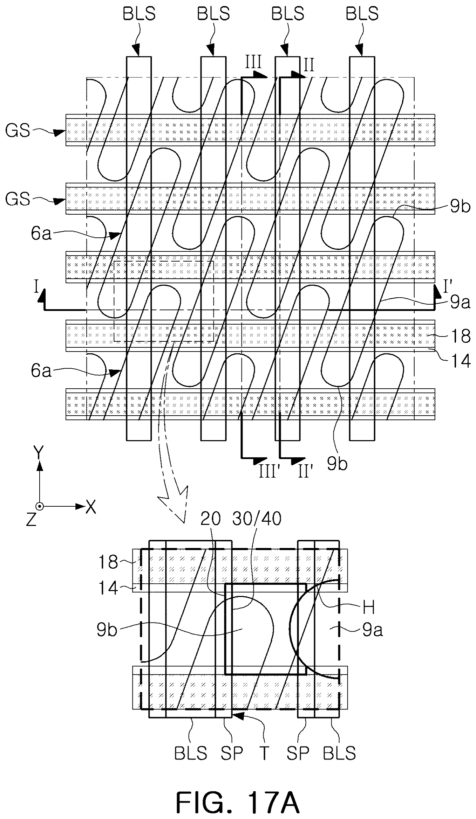

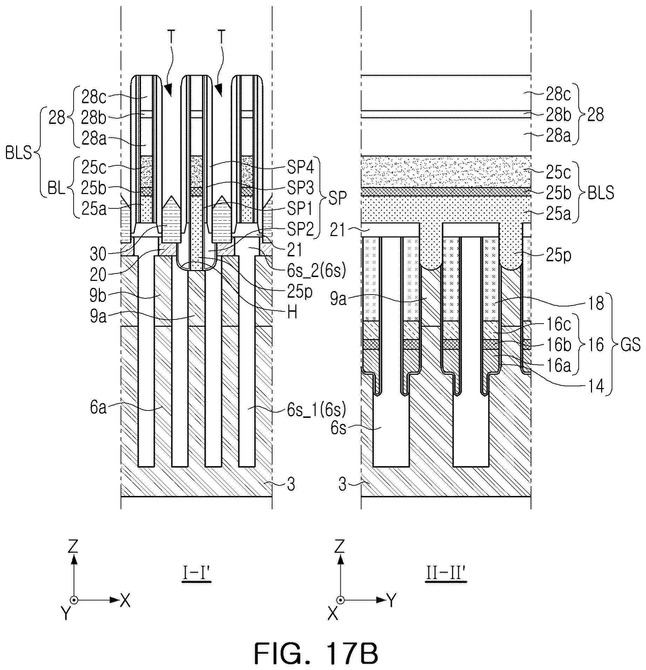

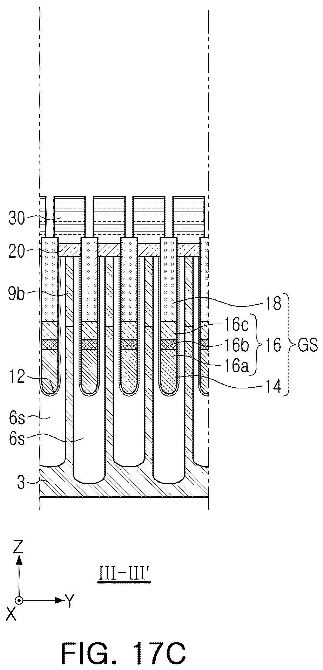

Referring to FIGS. 17A to 17C, a second contact plug 30 may be formed on a first contact plug 20. The second contact plugs 30 may be disposed in a trench T and may be spaced apart from each other in the Y-direction along the trench T.

In one or more embodiments, the second contact plug 30 may be formed by growing from an upper surface of the first contact plug 20 by a selective epitaxial growth method. The second contact plug 30 may include at least one of doped single crystal silicon and doped polysilicon. For example, the second contact plug 30 is grown from the first contact plug 20 including single crystal silicon, and may thus include single crystal silicon having the same crystal orientation as the first contact plug 20. According to one or more embodiments, a portion of the second contact plug 30 may include doped polysilicon or may include single-crystal silicon having a different crystal orientation from the first contact plug 20. The second contact plug 30 may include n-type impurities, and the doping concentration of the second contact plug 30 may be greater than the doping concentration of the first contact plug 20.

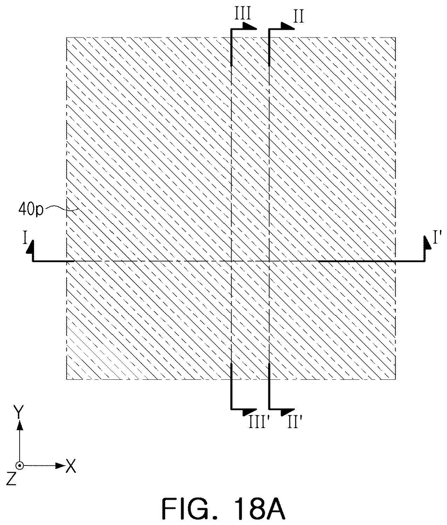

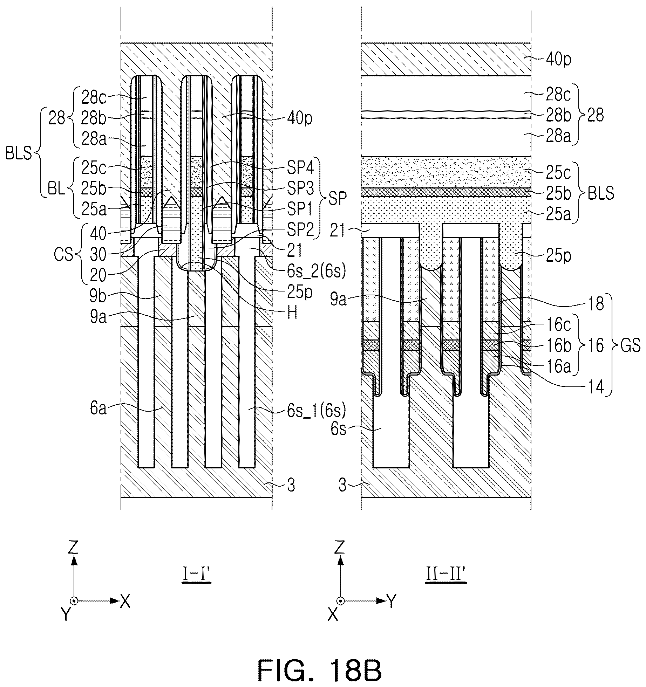

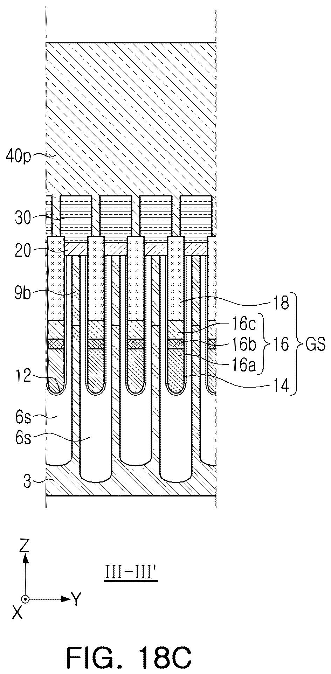

Referring to FIGS. 18A to 18C, a contact material layer 40p may be formed on the second contact plug 30. The contact material layer 40p may completely fill the trench T and cover the bit line structure BLS and the spacer structure SP. The contact material layer 40p may be formed by depositing doped polysilicon and annealing the polysilicon. The annealing process may include a melt laser annealing (MLA) method that heats polysilicon using a laser. If the trench T is formed deep enough to expose the second impurity region 9b of the active region 6a, there is a concern that the bit line contact 25p, the first spacer SP1, and the second spacer SP2 may be heated and deteriorated in the process of annealing the contact material layer 40p. However, according to one or more embodiments, the first contact plug 20 and the second contact plug 30 are formed on the second impurity region 9b, and the contact material layer 40p is formed on the second contact plug 30, and then the annealing process may be performed. By this method, a distance between a lower end of the contact material layer 40p and a lower end of the bit line contact 25p may be increased, so that the bit line contact 25p, the first spacer SP1 and the second spacer SP2 may be prevented from being deteriorated by the annealing process, and the occurrence of voids in the bit line contact 25p may be prevented or reduced. In addition, according to one or more embodiments, the distance between the lower end of the contact material layer 40p and the lower end of the bit line contact 25p may be increased without reducing the distance between the lower end of the bit line contact 25p and the upper surface of the gate electrode 16. Therefore, the electrical coupling of the bit line BL and the gate electrode 16 may be prevented or reduced.

Referring again to FIGS. 1 to 4, the fence structure 63 may be formed. The fence structure 63 may be formed by removing a portion of the contact material layer 40p so that the upper surface of the gate capping layer 18 is exposed by an anisotropic etching process, and then filling the space where the portion of the contact material layer 40p is removed with an insulating material. The fence structures may be formed to overlap the gate structure GS in the vertical direction between the bit line structures BLS. The fence structures 63 may be disposed to be spaced apart from each other in the X-direction and the Y-direction.

After forming the fence structures 63, the contact material layer 40p may be etched back so that the upper surface of the contact material layer 40p becomes a level lower than the upper surfaces of the fence structures 63, so that a third contact plug 40 may be formed. The first contact plug 20, the second contact plug 30, and the third contact plug 40 may constitute a contact structure CS. Contact structures CS may be alternately disposed with fence structures 63 along the Y-direction between bit line structures BLS.

A metal-semiconductor compound layer 66 and a landing pad 69 may be formed on the contact structure CS. An insulating material may be formed to cover the landing pad 69, and the insulating material may be planarized so that the upper surface of the landing pad 69 is exposed, thereby forming an insulating pattern 72. The landing pad 69 may be electrically connected to the second impurity region 9b through the contact structure CS. The landing pads 69 may be spatially separated from each other by the insulating patterns 72 and may be electrically insulated from each other. An etch stop layer 75 and a capacitor structure 80 may be formed on the landing pad 69 and the insulating pattern 72, thereby manufacturing a semiconductor device 100.

As set forth above, according to one or more embodiments, a third contact plug may be formed on first and second contact plugs. Accordingly, occurrence of voids in the bit line contact may be prevented or reduced during an annealing process for forming the third contact plug, and deterioration of the bit line contact may be prevented.

While one or more embodiments have been illustrated and described above, it will be apparent to those skilled in the art that modifications and variations could be made without departing from the scope of the present disclosure as defined by the appended claims.

Embodiments are set out in the following clauses:
Clause 1. A semiconductor device comprising:
   a substrate;
   an active region in the substrate;
   a device isolation layer defining the active region;
   a gate structure in the substrate and extending across the active region in a first horizontal direction;
   bit line structures on the substrate, extending in a second horizontal direction intersecting the first horizontal direction, and crossing the gate structure; and
   a contact structure between the bit line structures,
   wherein the contact structure comprises:
      a first contact plug in contact with the active region;
      a second contact plug on the first contact plug; and
      a third contact plug on the second contact plug, and
   wherein the device isolation layer comprises a lower portion that is lower than an upper surface of the active region, and an upper portion that is higher than the upper surface of the active region.
Clause 2. The semiconductor device of clause 1, wherein a lower surface of the first contact plug is in contact with the lower portion, and a side surface of the first contact plug is in contact with the upper portion.
Clause 3. The semiconductor device of clause 1 or clause 2, wherein the upper surface of the active region is in contact with the upper portion.
Clause 4. The semiconductor device of any of clauses 1 to 3, wherein a horizontal width of the upper portion in the first horizontal direction is larger than a horizontal width of the lower portion in the first horizontal direction.
Clause 5. The semiconductor device of any of clauses 1 to 4, further comprising a buffer layer extending in a horizontal direction between the device isolation layer and the bit line structures,
   wherein an upper surface of the first contact plug is in contact with a lower surface of the buffer layer.
Clause 6. The semiconductor device of clause 5, wherein a lower end of the third contact plug is at a level that is higher than a level of an upper surface of the buffer layer.
Clause 7. The semiconductor device of any of Clauses 1 to 6, wherein a lower end of the third contact plug is at a level that is higher than a level of the upper surface of the active region.

## Claims

1. A semiconductor device (100) comprising:
a substrate (3);
an active region (6a) in the substrate (3);
a device isolation layer (6s) defining the active region (6a);
a gate structure (GS) in the substrate (3) and extending across the active region (6a) in a first horizontal direction (X);
bit line structures (BLS) on the substrate (3), extending in a second horizontal direction (Y) intersecting the first horizontal direction (X), and crossing the gate structure (GS); and
a contact structure (CS) between the bit line structures (BLS),
wherein the contact structure (CS) comprises:
a first contact plug (20) in contact with the active region (6a);
a second contact plug (30) on the first contact plug (20); and
a third contact plug (40) on the second contact plug (30), and
wherein a first vertical central axis of the active region (6a), a second vertical central axis of the first contact plug (20), and a third vertical central axis of the third contact plug (40) are offset from each other in a cross-sectional view.

2. The semiconductor device (100) of claim 1, wherein each of the first contact plug (20), the second contact plug (30), and the third contact plug (40) comprises single crystal silicon.

3. The semiconductor device (100) of claim 1 or claim 2, wherein at least a portion of the first contact plug (20) has a crystal orientation that is different from a crystal orientation of the active region (6a).

4. The semiconductor device (100) of any preceding claim, wherein at least a portion of the second contact plug (30) has a crystal orientation that is different from a crystal orientation of the first contact plug (20).

5. The semiconductor device (100) of any preceding claim, wherein at least a portion of the third contact plug (34) has a crystal orientation that is different from a crystal orientation of the second contact plug (30).

6. The semiconductor device (100) of any preceding claim, wherein the first contact plug (20) has a first doping concentration, the second contact plug (30) has a second doping concentration, and the third contact plug (40) has a third doping concentration, and
wherein the second doping concentration is greater than the first doping concentration and is less than the third doping concentration.

7. The semiconductor device (100) of any preceding claim, wherein the first contact plug (20) comprises a recess (R1) in an upper surface,
wherein at least a portion of a side surface of the second contact plug (30) is in contact with the recess (R1), and
wherein at least a portion of a lower surface of the second contact plug (30) is in contact with the recess (R1).

8. The semiconductor device (100) of any preceding claim, wherein the first contact plug (20) comprises a first portion (20a) and a second portion (20b), and
wherein the second portion (20b) has a crystal orientation that is different from a crystal orientation of the first portion (20a).

9. The semiconductor device (100) of any preceding claim, wherein a side surface of the second contact plug (30) is in contact with the device isolation layer (6s).

10. The semiconductor device (100) of any preceding claim, wherein a width of the second contact plug (30) in the first horizontal direction (X) is the same as a width of the third contact plug (40) in the first horizontal direction (X).

11. The semiconductor device (100) of any preceding claim, wherein a lower surface of the first contact plug (20) is coplanar with an upper surface of the active region (6a).

12. The semiconductor device (100) of any preceding claim, wherein at least a portion of the second contact plug (30) is offset from the first contact plug (20) in the first horizontal direction (X).

13. The semiconductor device (100) of any preceding claim, wherein the device isolation layer (6s) comprises a lower portion (6s_1) that is lower than an upper surface of the active region (6a), and an upper portion (6s_2) that is higher than the upper surface of the active region (6a).

14. The semiconductor device (100) of claim 13, wherein a lower surface of the first contact plug (20) is in contact with the lower portion (6s_1), and a side surface of the first contact plug (20) is in contact with the upper portion (6s_2).

15. The semiconductor device (100) of claim 13 or claim 14, wherein the upper surface of the active region (6a) is in contact with the upper portion (6s_2).
